# EUROPÄISCHE PATENTSCHRIFT

(11) **EP 2 759 018 B1**
(45) Veröffentlichungstag und Bekanntmachung des Hinweises auf die Patenterteilung: **01.06.2016**
(21) Anmeldenummer: 12772241.1
(22) Anmeldetag: 07.09.2012
(51) Int. Cl.: H01M 10/42, H01M 10/48, G01R 31/36, H04Q 9/00, H01M 10/0525

(54) **BATTERIEMANAGEMENTSYSTEM, BATTERIE, KRAFTFAHRZEUG MIT BATTERIEMANAGEMENTSYSTEM SOWIE VERFAHREN ZUR ÜBERWACHUNG EINER BATTERIE**
BATTERY MANAGEMENT SYSTEM, BATTERY, MOTOR VEHICLE HAVING A BATTERY MANAGEMENT SYSTEM, AND METHOD FOR MONITORING A BATTERY
SYSTÈME DE GESTION DE BATTERIE, BATTERIE, VÉHICULE AUTOMOBILE AVEC SYSTÈME DE GESTION DE BATTERIE ET PROCÉDÉ DE SURVEILLANCE D'UNE BATTERIE

(30) Priorität: 19.09.2011 DE 102011082937
(43) Veröffentlichungstag der Anmeldung: 30.07.2014
(73) Patentinhaber: Robert Bosch GmbH, 70442 Stuttgart (DE); Samsung SDI Co., Ltd., Yongin-si, Gyeonggi-do 446-577 (KR)
(72) Erfinder: BUTZMANN, Stefan, 71717 Beilstein (DE)
(74) Vertreter: Bee, Joachim
(86) Internationale Anmeldenummer: PCT/EP2012/067477
(87) Internationale Veröffentlichungsnummer: WO 2013/041386

(56) Entgegenhaltungen:
- EP-A1- 2 148 384
- EP-A1- 2 330 431
- WO-A1-2013/010831
- WO-A2-2013/010832
- US-A1- 2010 185 405

## Beschreibung

Die vorliegende Erfindung betrifft ein Batteriemanagementsystem, eine Batterie mit dem Batteriemanagementsystem, ein Kraftfahrzeug mit dem Batteriemanagementsystem sowie ein Verfahren zur Überwachung einer Batterie. Insbesondere betrifft die Erfindung ein Batteriemanagementsystem sowie ein dazugehöriges Verfahren zur Ermittlung und Auswertung von mindestens einer Messgröße aus mindestens einem Batteriemodul.

### Stand der Technik

Es zeichnet sich ab, dass in Zukunft sowohl bei stationären Anwendungen, wie zum Beispiel Windkraftanlagen, in Fahrzeugen, wie zum Beispiel in Hybrid- und Elektrofahrzeugen, als auch im Consumer-Bereich, wie zum Beispiel bei Laptops und Mobiltelefonen, vermehrt neue Batteriesysteme zum Einsatz kommen werden, an die sehr hohe Anforderungen bezüglich deren Zuverlässigkeit, Sicherheit, Leistungsfähigkeit und Lebensdauer gestellt werden.

Für solche Aufgaben sind insbesondere Batterien mit Lithium-Ionen-Technologie geeignet. Sie zeichnen sich unter anderem durch hohe Energiedichte und eine geringe Selbstentladung aus. Definitionsgemäß bestehen Lithium-Ionen-Batterien aus zwei oder mehreren Lithium-Ionen-Zellen, die miteinander verschaltet sind. Lithium-Ionen-Zellen können durch parallele oder serielle Verschaltung zu Modulen und dann zu Batterien verschaltet werden. Typischerweise besteht ein Modul aus sechs oder mehr Zellen.

Aus der DE 10 2009 046 567 A1 ist eine Batterie bekannt, die aus mehreren Batteriemodulen aufgebaut ist, wobei die Batteriemodule mittels eines zentralen Batteriemanagementsystems überwacht werden.

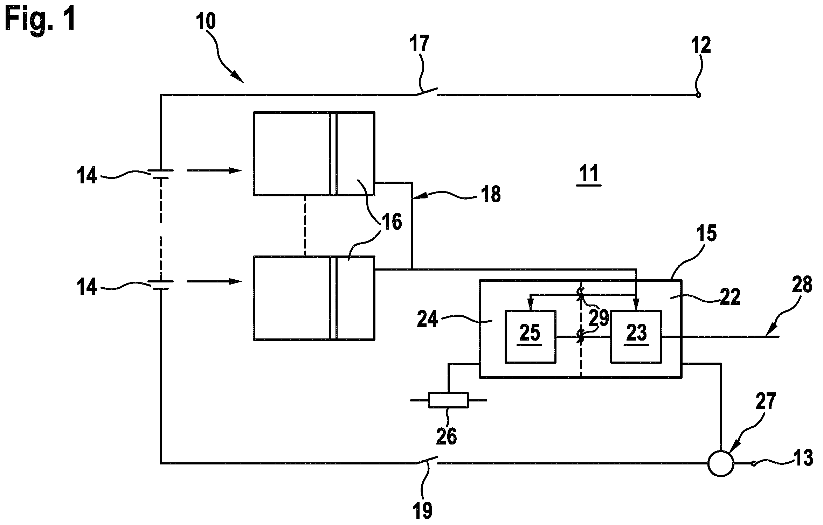

Wie in Figur 1 dargestellt ist, kann ein herkömmliches Batteriesystem 10 ein Batteriemanagementsystem 11 mit einem zentralen Steuergerät 15 aufweisen, welches mit mehreren Zellüberwachungseinheiten 16 (Englisch: "Cell Supervision Circuit"; CSC) kommuniziert, die jeweils mehreren Batteriezellen 14 oder Batteriemodulen zugeordnet sind. Im Folgenden kann je nach Zusammenhang die Gesamtheit der in Batteriemodulen angeordneten Batteriezellen 14 mit oder ohne das dazugehörige Batteriemanagementsystem 11 als Batterie bezeichnet werden. Die Batteriezellen 14 sind in Batteriemodule gruppiert, wobei die genaue Aufteilung der Batteriezellen in die Batteriemodule in Figur 1 nicht gezeigt ist. Das Batteriemanagementsystem 11 kann mit Batteriezellen 14 oder Batteriemodulen in einem gemeinsamen Gehäuse (nicht gezeigt) untergebracht sein. Die Batteriemodule können jeweils ein eigenes Gehäuse aufweisen. Mittels einer Anordnung der Batteriezellen 14 in Batteriemodule kann eine bessere Skalierbarkeit erreicht werden. Um die ordnungsgemäße Funktion der Batteriezellen 14 zu überwachen, werden die Batteriezellen durch die mehreren CSCs 16 überwacht. Dabei sind typischerweise einer CSC 16 jeweils zwei Batteriemodule zugeordnet. Eine CSC 16 beinhaltet eine Messelektronik, die die Spannung und weitere Parameter überwacht. Die mittels der CSC 16 gewonnenen Informationen werden über einen Kommunikationsbus 18, beispielsweise einen CAN-Bus, an ein zentrales Steuergerät 15 gesendet, das die Daten aller Batteriezellen 14 auswertet und bei Abweichungen von definierten Parametern korrigierend eingreift oder notfalls die Schütze 17, 19 öffnet und das Batteriesystem 10 abschaltet.

Das Steuergerät 15 weist eine Niedervoltseite beziehungsweise ein niedervoltseitiges Teil 22 mit einem Mikrocontroller 23 und eine Hochvoltseite beziehungsweise ein hochvoltseitiges Teil 24 mit einem Mikrocontroller 25 auf. Die Niedervoltseite 22 und die Hochvoltseite 24 sind über eine galvanische Trennung 29 miteinander verbunden. Die Niedervoltseite 22 ist mit einem Hall-Sensor 27 zum Messen des Batteriestroms verbunden, wobei die Hochvoltseite 24 mit einem Shunt 26 zur Messung des Batteriestroms verbunden ist. Das Steuergerät 15 kommuniziert mit der Fahrzeugelektronik mittels des Busses 28. Die elektrischen Anschlüsse 12, 13 dienen zur Energieversorgung für beispielsweise ein Kraftfahrzeug und/oder zur Wiederaufladung der Batterie.

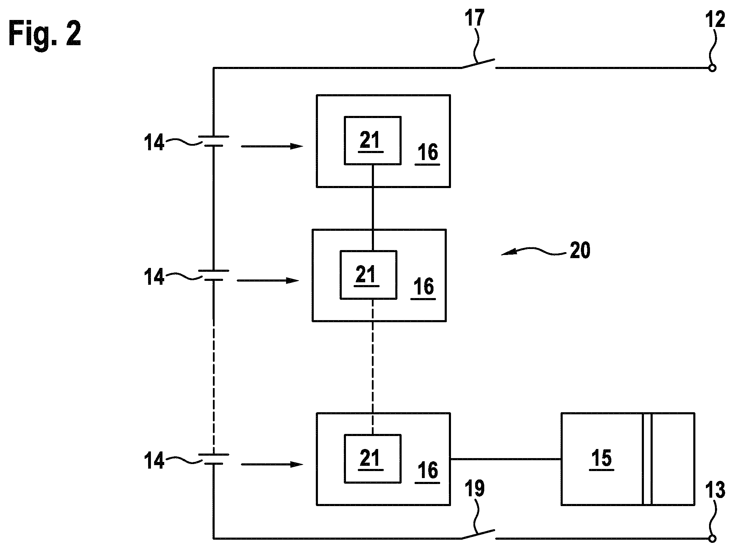

Eine weitere Topologie zur Zellüberwachung ist in Figur 2 dargestellt. Hier übertragen die CSCs 16 ihre Informationen über eine Daisy-Chain 32. Eine CSC 16 leitet dabei ihr Datenpaket an die Nächste, die ihre Informationen hinzufügt und wiederum an die nächste CSC 16 weitergibt. In jeder CSC 16 ist eine Zellspannungsmesseinheit 21 (CVM) angeordnet. Der Strang aus den in Daisy-Chain-Topologie angeordneten CSCs 16 ist wiederum mit dem Steuergerät 15 verbunden.

Die Überwachung der Zellspannungen sowie der Ströme und der Temperatur hinsichtlich Über- oder Unterschreitung bestimmter Grenzwerte ist ein wesentlicher Sicherheitsfaktor in einem Batteriesystem. ISO-Normen, insbesondere ISO 26262: Funktionale Sicherheit von E/E Systemen in KFZ, erfordern es, ein gewisses Sicherheitsniveau ASIL (Englisch: "automotive safety integrity level") zu erreichen.

Um eine ausreichende funktionale Sicherheit für das Batteriesystem 10 zu gewährleisten, werden die Daten der CSCs 16 sowohl auf der Hochvoltseite 24 als auch auf der Niedervoltseite 22 des Steuergerätes 15 in den zwei redundanten Mikrocontrollern 23, 25 ausgewertet und miteinander verglichen. Der hochvoltseitige Mikrocontroller 25 verwendet dabei die Gesamtspannung des Packs, das heißt aller Batteriemodule sowie den Gesamtstrom, der beispielsweise mittels des Shunts 26 gemessen wird. Der niedervoltseitige Mikrocontroller 23 misst die Spannung der einzelnen Batteriezellen 14 sowie den Strom, der beispielsweise über den Hall-Sensor 27 ermittelt wird.

Strom und Spannung müssen zum selben Zeitpunkt abgefragt werden, um plausible Werte errechnen zu können. Um die Werte der Hochvoltseite 24 und der Niedervoltseite 22 vergleichen zu können, müssen auch diese Daten parallel ermittelt werden. Um eine synchrone Datenbasis zu erhalten, werden daher durch das Steuergerät 15 zeitgleich Anfragen über den Kommunikationsbus 18 an die CSCs 16, Hall-Sensoren 27 und den Shunt 26 gesendet, die dann idealerweise zeitgleich zurückgemeldet werden. Zur Erfüllung eines hohen ASIL-Levels hat das Steuergerät ferner zahlreiche Sicherungs- und Kontrollfunktionen, die unter anderem eine Selbstüberwachung des Steuergeräts 15 umfassen. Außerdem überwacht das Steuergerät die CSCs 16, wobei die Daten sowohl für den hochvoltseitigen Mikrocontroller 25 als auch für den niedervoltseitigen Mikrocontroller 23 durch dieselben CSCs 16 erfasst werden.

Vorrichtungen zur Spannungsmessung der Zellen eines Batteriepacks sind auch aus den Patentanmeldungen EP 2 330 431 A1 und US 2010/185405 A1 benannt. Die bekannten Batteriemanagementsysteme haben den Nachteil, dass das Steuergerät aufwendig programmiert werden muss, um die Plausibilität der CSC-Daten berechnen zu können und so die notwendige funktionale Sicherheit zu gewährleisten und Unzulänglichkeiten der oft nur relativ einfach ausgeführten Datenerfassung auszugleichen. Dazu müssen oft sehr komplexe Rechenmodelle angewandt werden. Die Daten werden, wie bereits dargestellt, typischerweise unter Verwendung einer CAN-Bus- oder Daisy-Chain-basierten Topologie aufgenommen. Bei den bekannten Topologien zur Überwachung von Batteriezellen erfordern eine hohe funktionale Sicherheit und somit ein hohes ASIL-Level daher einen nicht geringen Software-Aufwand. Zusätzlich zu dem hohen Rechenaufwand wird der Kommunikationsbus, vorzugsweise ein CAN-Bus, mit vielen zu übertragenden Daten beansprucht, so dass dieser an seine Kapazitätsgrenzen stößt.

### Offenbarung der Erfindung

Es werden ein Batteriemanagementsystem und ein dazugehöriges Verfahren gemäß den unabhängigen Patentansprüchen 1 und 8 geschaffen. Erfindungsgemäß weist ein Batteriemanagementsystem ein Steuergerät mit einem ersten, auf einer Niedervoltseite des Steuergeräts angeordneten Mikrocontroller und einem zweiten, auf einer Hochvoltseite des Steuergeräts angeordneten Mikrocontroller auf sowie mehrere erste Spannungsmesseinheiten, die jeweils mindestens einem Batteriemodul der Batterie zugeordnet sind, eine erste Kommunikationsverbindung zur Übermittlung von Spannungswerten von den ersten Spannungsmesseinheiten zu dem ersten Mikrocontroller, mehrere zweite Spannungsmesseinheiten und eine zweite Kommunikationsverbindung zur Übermittlung von Spannungswerten von den zweiten Spannungsmesseinheiten zu dem zweiten Mikrocontroller. Die ersten Spannungsmesseinheiten oder die zweiten Spannungsmesseinheiten sind als Min-Max-Messeinheiten ausgebildet derart, einen minimalen und einen maximalen Spannungswert der Batteriezellen in den der jeweiligen Min-Max-Messeinheit zugeordneten Batteriemodulen zu erfassen und dazwischenliegende Spannungsmesswerte zu verwerfen.

Das erfindungsgemäße Verfahren zur Überwachung einer Batterie umfasst grundsätzlich folgende Schritte: Erfassen von Spannungswerten für eine Ermittlung des Ladezustandes von Batteriezellen oder Batteriemodulen mittels einer ersten Kommunikationstopologie; Erfassen von Spannungswerten mittels einer zweiten, von der ersten Kommunikationstopologie unabhängigen Kommunikationstopologie und unter Verwendung von Min-Max-Messeinheiten, für eine Überwachung der Einhaltung einer maximalen und einer minimalen Spannung.

Mit dem erfindungsgemäßen Batteriemanagementsystem steht vorteilhaft eine Topologie zur Verfügung, durch die der erforderliche Software-Aufwand und die Datenrate im Kommunikationsbus reduziert werden und gleichzeitig ein hohes ASIL-Level erreicht wird.

Dies wird insbesondere durch die erfindungsgemäße redundante Ausführung der Bauteile, in Kombination mit dem erfindungsgemäßen Einsatz von Min-Max-Messeinheiten innerhalb eines Strangs von Spannungsmesseinheiten erreicht. Da mindestens auf einer Seite die Messeinheiten zur Spannungserfassung eingesetzt werden, die jeweils nur die minimale und maximale Spannung der Zellen übertragen, werden nun nur noch zwei Zellspannungen pro Batteriemodul an beispielsweise den niedervoltseitigen Mikrocontroller übermittelt und somit der Datentransfer auf dem Kommunikationsbus maßgeblich reduziert. Dies ist unter anderem auch vorteilhaft bei einem CAN-Bus, der üblicherweise für zahlreiche Komponenten in beispielsweise einem Kraftfahrzeug zum Datenaustausch dient. Ferner werden Berechnungen im empfangenden Mikrocontroller vereinfacht, da nur noch zwei Werte ausgewertet werden müssen.

Es wird eine redundante Ausführung des Batteriemanagementsystems mit vergleichsweise geringen Kosten erreicht unter anderem, da kostengünstige Min-Max-Messeinheiten auf eine vorteilhafte Weise verwendet werden als Teil der erfindungsgemäßen Überwachungs-Topologie.

Vorteilhafte Weiterbildungen der Erfindung sind in den Unteransprüchen angegeben und in der Beschreibung beschrieben.
Gemäß einem Ausführungsbeispiel sind die ersten Spannungsmesseinheiten mittels der ersten Kommunikationsverbindung gemäß einer ersten Kommunikationstopologie verbunden und die zweiten Spannungsmesseinheiten mittels der zweiten Kommunikationsverbindung gemäß einer zweiten, zu der ersten Kommunikationstopologie unterschiedlichen Kommunikationstopologie verbunden.
Da bei diesem Ausführungsbeispiel vorteilhaft zwei unterschiedliche Topologien eingesetzt werden, wird damit die funktionale Sicherheit weiter erhöht.
Bevorzugt wird ein paralleler Einsatz einer CAN-Bus-basierten Topologie und einer Daisy-Chain-Topologie verwendet. Vorteilhaft kann die erste Kommunikationstopologie eine Daisy-Chain-Anordnung aufweisen, während die zweite Kommunikationstopologie eine CAN-Bus-Verbindung aufweist, oder umgekehrt.
Gemäß einer vorteilhaften Weiterbildung der Erfindung ist das Batteriemanagementsystem derart ausgebildet, dass der erste und der zweite Mikrocontroller unabhängig voneinander arbeiten.
Es werden somit Redundanzen gleichzeitig sowohl bei den CSC, dem Kommunikationsbus und auch bei dem Mikrocontroller im Steuergerät erreicht. Hierbei wird aufgrund der unabhängigen Ausgestaltung insbesondere weiterhin begünstigt, dass eine Synchronisation zwischen hochvoltseitigem Mikrocontroller und niedervoltseitigem Mikrocontroller nicht mehr oder nur noch minimal notwendig ist. Die Komplexität der Programmierung des Steuergeräts kann dadurch weiter verringert werden.

Gemäß der Erfindung ist der erste, niedervoltseitige Mikrocontroller mit einem ersten Stromsensor, insbesondere einem Hall-Sensor, verbunden, wobei der zweite, hochvoltseitige Mikrocontroller mit einem zweiten, zu dem ersten Stromsensor unterschiedlichen Stromsensor, insbesondere einem Stromsensor, der einen Shuntwiderstand aufweist, verbunden ist.

Bei dieser vorteilhaften Ausführungsform wird weiterhin die funktionale Sicherheit erhöht, indem verschiedene Strommesssysteme mit den erfindungsgemäßen CSC-Strängen kombiniert werden.

Gemäß einem anderen Ausführungsbeispiel ist der erste, niedervoltseitige Mikrocontroller zur Auswertung von elektrischen Spannungen eingerichtet und weist ferner eine Sicherheitsfunktion auf, und der zweite, hochvoltseitige Mikrocontroller ist dazu eingerichtet, einen Ladezustand (SOC) zu ermitteln.

Bei diesem Ausführungsbeispiel wird besonders vorteilhaft eine optimierte Aufteilung erreicht, welche eine hohe Funktionalität mit einem gleichzeitig hohen Sicherheitsniveau vereinigt.

Gemäß einer anderen vorteilhaften Weiterbildung der Erfindung sind sowohl die ersten als auch die zweiten Messeinheiten als Min-Max-Messeinheiten ausgebildet.

Dadurch können weiterhin Kosten und Berechnungen gespart werden.

Gemäß einem Ausführungsbeispiel der Erfindung weist das Batteriemanagementsystem mehrere Zellüberwachungseinheiten auf, in denen jeweils einer von den ersten Spannungsmesseinheiten und einer von den zweiten Spannungsmesseinheiten und ein zusätzlicher Mikrocontroller angeordnet sind, wobei die Spannungsmesseinheiten einer Zellüberwachungseinheit an gemeinsame Eingänge der Zellüberwachungseinheit gekoppelt sind und wobei der Mikrocontroller in der Zellüberwachungseinheit eingerichtet ist, Daten von einer der Spannungsmesseinheiten der jeweiligen Zellüberwachungseinheit auszuwerten.

Bei diesem Ausführungsbeispiel kann der Mikrocontroller in einer Zellüberwachungseinheit vorteilhaft weitere Auswerte- und Sicherheitsfunktionen bereitstellen. Gleichzeitig wird durch die besondere Wahl der Ausgestaltung mit Zellüberwachungseinheiten die Skalierbarkeit des Systems begünstigt.

Ferner wird erfindungsgemäß eine Batterie mit einem
Batteriemanagementsystem nach einem der vorhergehenden Ansprüche geschaffen.

Nach einem bevorzugten Ausführungsbeispiel ist die Batterie eine Lithium-lonen-Batterie.

Ferner wird ein Kraftfahrzeug mit dem erfindungsgemäßen Batteriemanagementsystem geschaffen, wobei die zu überwachende Batterie mit einem Antriebssystem des Kraftfahrzeugs verbunden ist.

### Zeichnungen

Ausführungsbeispiele der Erfindung werden anhand der Zeichnungen und der nachfolgenden Beschreibung näher erläutert. Es zeigen:
Figur 1 eine Batterie mit einem Batteriemanagementsystem nach dem Stand der Technik,
Figur 2 eine bekannte Daisy-Chain-Topologie,
Figur 3 eine Batterie mit einem Batteriemanagementsystem zur Überwachung von Batteriezellen der Batterie nach einem Ausführungsbeispiel der Erfindung, mit Min-Max-Messeinheiten auf der Niedervoltseite,
Figur 4 eine Batterie mit einem Batteriemanagementsystem zur Überwachung von Batteriezellen der Batterie nach einem anderen Ausführungsbeispiel der Erfindung mit Min-Max-Messeinheiten auf der Hochvoltseite, und
Figur 5 eine Batterie mit einem Batteriemanagementsystem zur Überwachung von Batteriezellen der Batterie nach noch einem anderen Ausführungsbeispiel der Erfindung mit Min-Max-Messeinheiten auf der Niedervoltseite und auf der Hochvoltseite.

### Ausführungsformen der Erfindung

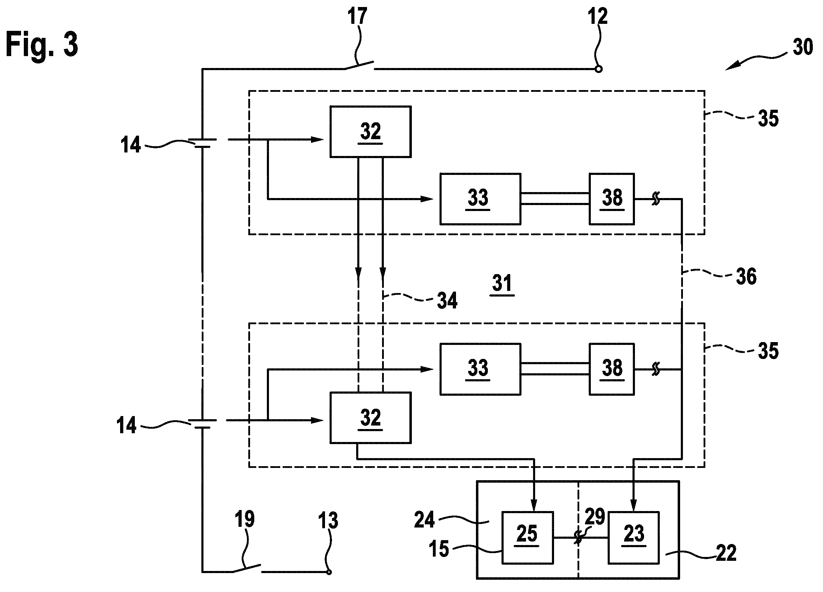

In Figur 3 ist eine Batterie mit einem Batteriemanagementsystem 31 zur Überwachung von Batteriezellen 14 der Batterie nach einem Ausführungsbeispiel der Erfindung gezeigt, wobei auf der Niedervoltseite des Batteriemanagementsystems 31 Min-Max-Messeinheiten 33 angeordnet sind. Dabei wird für die Ausgestaltung des Batteriemanagementsystems 11 auf Messeinheiten 33 zurückgegriffen, die nur die minimale und die maximale Spannung aller zugewiesenen Zellen an das Steuergerät melden. Diese Min-Max-Messeinheiten 33 vergleichen dabei den Zustand einer zugewiesenen Batteriezelle 14 mit dem Zustand der vorgeschalteten Zelle 14. So kann bei der Ermittlung der maximalen Spannung aller Batteriezellen 14 die höhere Spannung der beiden Batteriezellen 14 an die nächste Messeinheit 33 übermittelt werden, wo sie wieder mit der Zelle 14 verglichen werden. Am Ende kommuniziert die letzte Messeinheit nur den höchsten Spannungswert an das Steuergerät. Analog wird auch die minimale Spannung aller Zellen 14 ermittelt. Wie in der Figur 3 angedeutet ist, kommuniziert eine Min-Max-Messeinheit jeweils zwei Werte weiter an einen Zellüberwachungs-Mikrocontroller 38, der die beiden Werte auswertet und das Ergebnis über den CAN-Bus 36 übermittelt.

Der hochvoltseitige Strang ist mit Spannungsmesseinheiten 32 bestückt. Gemäß einer erfindungsgemäßen Variante dieses Ausführungsbeispiels sind die Spannungsmesseinheiten als Spannungsüberwachungseinheiten CVM (Englisch: Cell Voltage Monitoring) ausgebildet. Die CVM können zusätzlich andere physikalische Größen wie beispielsweise die Temperatur der zugeordneten Batteriemodule überwachen.

Es stehen vorteilhaft zwei unabhängig voneinander agierende Zellspannungsmesseinheiten 32, 33 in einer CSC zur Verfügung. Ein Strang von Zellspannungsmesseinheiten 32 versorgt den hochvoltseitigen Mikrocontroller 25 im Steuergerät 15, der andere parallel den niederspannungsseitigen Mikrocontroller 23. Es werden parallel zwei verschiedene Arten von Bussen 34, 36 oder Kommunikationstopologien verwendet. So kann auf der einen Seite des Steuergeräts 15, beispielsweise auf der Hochvoltseite 24, über eine Daisy-Chain kommuniziert werden, auf der anderen über einen CAN-Bus. Die Erfindung ist aber nicht auf bestimmte Arten von Kommunikationsbussen beschränkt.

Da der niedervoltseitige Strang zur Überwachung der Spannung mit Min-Max-Messeinheiten 33 bestückt ist, wird auf eine einfache und kostengünstige Weise eine erhöhte Redundanz geschaffen. Ferner wird dabei eine ausreichende funktionale Sicherheit erreicht, bei der es keine Rolle spielt, wie die genaue Spannung der Batteriezellen 14 ist. Es ist vor allem relevant, definierte Ober- und Untergrenzen für Zellspannungen einzuhalten, die durch die Min-Max-Messeinheiten 33 erkannt werden. Zudem müssen die Spannungswerte der Batteriezellen 14 in einem engen Bereich beieinanderliegen, was typischerweise auch der Fall ist und was auch durch die Min-Max-Messeinheiten 33 erkannt wird. Sobald diese Werte maßgeblich auseinanderlaufen, liegt ein Fehler vor, der letzten Endes zum Abschalten des Batteriesystems 10 führt.

In dem Ausführungsbeispiel nach Figur 1 übernimmt die Berechnung des SOC die Hochvoltseite 24, die Niedervoltseite 22 übernimmt die Sicherheitsfunktion. Die Hochvoltseite 24 arbeitet unabhängig von der Niedervoltseite 22. Durch den redundanten Aufbau der CSCs 35 kann eine hohe funktionale Sicherheit und somit ein höheres ASIL-Level erreicht werden, ohne dass das Steuergerät 15 dazu komplexe Fehlermöglichkeitsberechnungen durchführen muss.

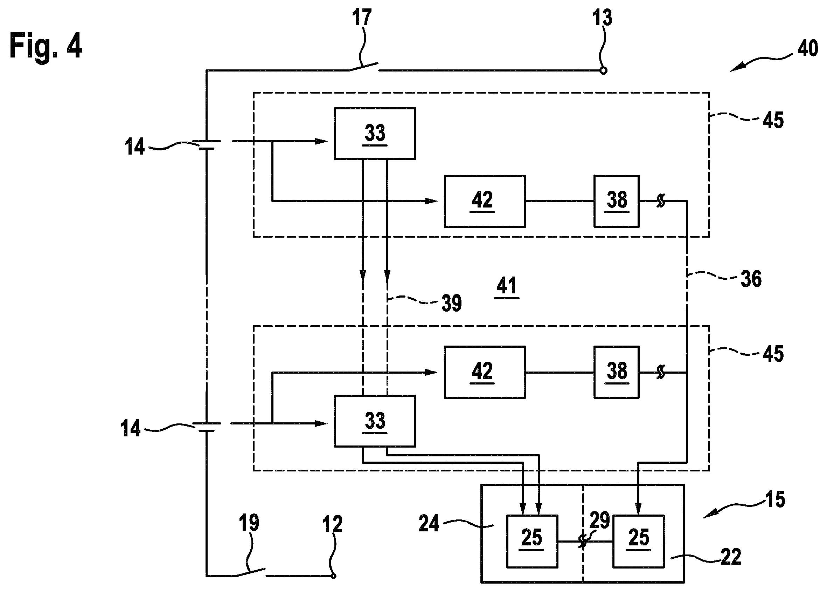

In Figur 4 wird eine Batterie mit einem Batteriemanagementsystem 41 zur Überwachung von Batteriezellen 14 der Batterie nach einem anderen Ausführungsbeispiel gezeigt. Im Unterschied zu dem in Figur 3 gezeigten Ausführungsbeispiel sind die Min-Max-Messeinheiten dabei hochvoltseitig, das heißt in dem mit dem hochvoltseitigen Mikrocontroller 25 verbundenen Strang auf Messeinheiten angeordnet. Der hochvoltseitige Strang dient zur Überwachung der Spannung.

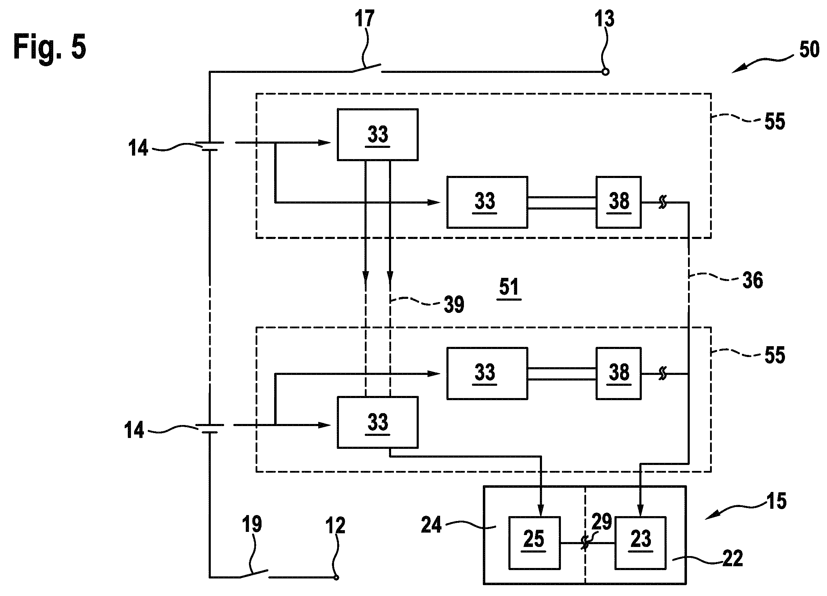

Alternativ können beide Messeinheiten, das heißt sowohl die hochvoltseitigen als auch die niedervoltseitigen Messeinheiten durch Min-Max-Messeinheiten 33 ersetzt werden, wie in Figur 5 gezeigt ist. Dadurch können weitere Kosten und Berechnungen gespart werden. Die Berechnung des SOC würde nur minimal ungenauer werden, da die Zellspannungen in engen Bereichen beieinanderliegen. Es reicht für die Berechnung also ein Mittelwert. Sobald die Zellspannungen auseinanderlaufen, liegt sowieso ein Fehler vor, der zum Abschalten des Systems führt. Der SOC spielt dann keine Rolle mehr.

Ein Fachmann erkennt, dass bei der vorliegenden Erfindung zahlreiche Variationen und Modifizierungen vorgenommen werden können, ohne den Rahmen der unabhängigen Ansprüche zu verlassen. Zwar wird darauf hingewiesen, dass die Erfindung bevorzugt bei Lithium-Ionen-Batterien verwendet wird. Stattdessen kann die Erfindung aber auch auf andere Batteriearten vorteilhaft angewandt werden.

## Patentansprüche

1. Batteriemanagementsystem (31, 41, 51), aufweisend:
ein Steuergerät (15) mit einem ersten, auf einer Niedervoltseite (22) des Steuergeräts (15) angeordneten Mikrocontroller (23) und einem zweiten, auf einer Hochvoltseite (24) des Steuergeräts (15) angeordneten Mikrocontroller (25), und
mehrere erste Spannungsmesseinheiten (32, 42), die jeweils mindestens einem Batteriemodul der Batterie zugeordnet sind, **gekennzeichnet durch** eine erste Kommunikationsverbindung (36) zur Übermittlung von Spannungswerten von den ersten Spannungsmesseinheiten (32, 42) zu dem ersten Mikrocontroller (23),
mehrere zweite Spannungsmesseinheiten (32, 42),
eine zweite Kommunikationsverbindung (34, 39) zur Übermittlung von Spannungswerten von den zweiten Spannungsmesseinheiten (32, 42) zu dem zweiten Mikrocontroller (25),
wobei die ersten oder die zweiten Spannungsmesseinheiten (32, 42) als Min-Max-Messeinheiten (33) ausgebildet sind derart, einen minimalen und
einen maximalen Spannungswert der Batteriezellen (14) in den der jeweiligen Min-Max-Messeinheit (33) zugeordneten Batteriemodulen zu erfassen und dazwischenliegende Spannungsmesswerte zu verwerfen,
**dadurch** gekennzeichnet, dass der erste, niedervoltseitige Mikrocontroller (23) mit einem ersten Stromsensor, insbesondere einem Hall-Sensor (27), verbunden ist, und der zweite, hochvoltseitige Mikrocontroller (25) mit einem zweiten, zu dem ersten Stromsensor unterschiedlichen Stromsensor,
insbesondere einem einen Shuntwiderstand (26) aufweisenden Stromsensor, verbunden ist.

2. Batteriemanagementsystem (31, 41, 51) nach Anspruch 1, wobei die ersten Spannungsmesseinheiten (42) mittels der ersten Kommunikationsverbindung (36) gemäß einer ersten Kommunikationstopologie verbunden sind und die zweiten Spannungsmesseinheiten (32) mittels der zweiten Kommunikationsverbindung (34) gemäß einer zweiten, zu der ersten Kommunikationstopologie unterschiedlichen Kommunikationstopologie verbunden sind.

3. Batteriemanagementsystem (31, 41, 51) nach Anspruch 1 oder 2, wobei die erste Kommunikationstopologie eine Daisy-Chain-Anordnung (20) aufweist und die zweite Kommunikationstopologie eine CAN-Bus-Verbindung aufweist, oder umgekehrt.

4. Batteriemanagementsystem (31, 41, 51) nach einem der vorhergehenden Ansprüche, derart ausgebildet, dass der erste und der zweite Mikrocontroller (23, 25) unabhängig voneinander arbeiten.

5. Batteriemanagementsystem (31, 41, 51) nach einem der vorhergehenden Ansprüche, wobei der erste, niedervoltseitige Mikrocontroller (23) zur Auswertung von elektrischen Spannungen eingerichtet ist und ferner eine Sicherheitsfunktion aufweist und der zweite, hochvoltseitige Mikrocontroller (25) dazu eingerichtet ist, einen Ladezustand (SOC) zu ermitteln.

6. Batteriemanagementsystem (31, 41, 51) nach einem der vorhergehenden Ansprüche, wobei sowohl die ersten als auch die zweiten Messeinheiten (32, 42) als Min-Max-Messeinheiten (33) ausgebildet sind.

7. Batteriemanagementsystem (31, 41, 51) nach einem der vorhergehenden Ansprüche, aufweisend mehrere Zellüberwachungseinheiten (35, 45, 55), ausgestattet mit jeweils einer von den ersten Spannungsmesseinheiten und einer von den zweiten Spannungsmesseinheiten und mit einem Mikrocontroller (38), wobei die Spannungsmesseinheiten einer Zellüberwachungseinheit (35, 45, 55) an gemeinsame Eingänge der Zellüberwachungseinheit (35, 45, 55) gekoppelt sind und wobei der Mikrocontroller (38) in der Zellüberwachungseinheit (35, 45, 55) eingerichtet ist, Daten von einer der Spannungsmesseinheiten (32, 42) der jeweiligen Zellüberwachungseinheit (35, 45, 55) auszuwerten.

8. Verfahren zur Überwachung einer Batterie, bei dem ein Ladezustand (SOC) ermittelt wird und das Vorliegen von minimalen und maximalen Spannungen überwacht wird, **gekennzeichnet durch** die Verwendung von unterschiedlichen, unabhängig voneinander arbeitenden Kommunikationstopologien, zur Erfassung der Spannungswerte für die Ermittlung des Ladezustandes einerseits und zur Erfassung der Spannungswerte für die Überwachung der minimalen und maximalen Spannungen andererseits, wobei zumindest für die Erfassung der Spannungswerte für die Überwachung der minimalen und maximalen Spannungswerte Min-Max-Messeinheiten (33) gemäß dem Anspruch 1 verwendet werden.

9. Batterie mit einem Batteriemanagementsystem (31, 41, 51) nach einem der Ansprüche 1 bits 7

10. Kraftfahrzeug mit einem Batteriemanagementsystem (31, 41, 51) nach einem der Ansprüche 1 bis 7 wobei die zu überwachende Batterie mit einem Antriebssystem des Kraftfahrzeugs verbunden ist.

## Claims

1. Battery management system (31, 41, 51), comprising:
a control device (15) having a first microcontroller (23) arranged on a low-voltage side (22) of the control device (15) and a second microcontroller (25) arranged on a high-voltage side (24) of the control device (15), and
a plurality of first voltage measuring units (32, 42), which are each assigned to at least one battery module of the battery, **characterized by**
a first communication link (36) for transmitting voltage values from the first voltage measuring units (32, 42) to the first microcontroller (23),
a plurality of second voltage measuring units (32, 42),
a second communication link (34, 39) for transmitting voltage values from the second voltage measuring units (32, 42) to the second microcontroller (25),
wherein the first or second voltage measuring units (32, 42) are in the form of min/max measuring units (33) in order to detect a minimum and a maximum voltage value of the battery cells (14) in the battery modules assigned to the respective min/max measuring unit (33) and to reject voltage measured values therebetween, **characterized in that** the first microcontroller (23) on the low-voltage side is connected to a first current sensor, in particular a Hall sensor (27), and the second microcontroller (25) on the high-voltage side is connected to a second current sensor which is different than the first current sensor, in particular a current sensor having a shunt resistor (26).

2. Battery management system (31, 41, 51) according to Claim 1, wherein the first voltage measuring units (42) are connected by means of the first communication link (36) in accordance with a first communication topology and the second, voltage measuring units (32) are connected by means of the second communication link (34) in accordance with a second communication topology, which is different than the first communication topology.

3. Battery management system (31, 41, 51) according to Claim 1 or 2, wherein the first communication topology comprises a daisy chain arrangement (20) and the second communication topology comprises a CAN bus link, or vice versa.

4. Battery management system (31, 41, 51) according to one of the preceding claims, which is designed in such a way that the first and second microcontrollers (23, 25) operate independently of one another.

5. Battery management system (31, 41, 51) according to one of the preceding claims, wherein the first microcontroller (23) on the low-voltage side is deigned to evaluate electrical voltages and furthermore has a safety function, and the second microcontroller (25) on the high-voltage side is designed to determine a state of charge (SOC).

6. Battery management system (31, 41, 51) according to one of the preceding claims, wherein both the first and the second measuring units (32, 42) are in the form of min/max measuring units (33).

7. Battery management system (31, 41, 51) according to one of the preceding claims, comprising a plurality of cell monitoring units (34, 45, 55), equipped with in each case one of the first voltage measuring units and one of the voltage measuring units and with a microcontroller (38), wherein the voltage measuring units of one cell monitoring unit (35, 45, 55) are coupled to common inputs of the cell monitoring unit (35, 45, 55), and wherein the microcontroller (38) in the cell monitoring unit (35, 45, 55) is designed to evaluate data from one of the voltage measuring units (32, 42) of the respective cell monitoring unit (35, 45, 55).

8. Method for monitoring a battery, in which a state of charge (SOC) is determined and the presence of minimum and maximum voltages is monitored, **characterized by** the use of different communication topologies operating independently of one another for detecting the voltage values for determining the state of charge, on the one hand, and for detecting the voltage values for monitoring the minimum and maximum voltages, on the other hand, wherein min/max measuring units (33) according to claim 1 are used at least for detecting the voltage values for the monitoring of the minimum and maximum voltage values.

9. Battery comprising a battery management system (31, 41, 51) according to one of Claims 1 to 7.

10. Motor vehicle comprising a battery management system (31, 41, 51) according to one of Claims 1 to 7, wherein the battery to be monitored is connected to a drive system of the motor vehicle.

## Revendications

1. Système de gestion de batterie (31, 41, 51), comprenant :
un contrôleur (15) doté d'un premier microcontrôleur (23) disposé sur un côté basse tension (22) du contrôleur (15) et un deuxième microcontrôleur (25) disposé sur un côté haute tension (24) du contrôleur (15), et
plusieurs premières unités de mesure de tension (32, 42) qui sont respectivement associées à au moins un module de batterie de la batterie, **caractérisé par** une première liaison de communication (36) destinée à la transmission de valeurs de tension des premières unités de mesure de tension (32, 42) au premier microcontrôleur (23),
plusieurs deuxièmes unités de mesure de tension (32, 42),
une deuxième liaison de communication (34, 39) destinée à la transmission de valeurs de tension des deuxièmes unités de mesure de tension (32, 42) au deuxième microcontrôleur (25),
les premières et deuxièmes unités de mesure de tension (32, 42) étant réalisées sous la forme d'unités de mesure min-max (33) pour détecter une valeur de tension minimale et une valeur de tension maximale des cellules de batterie (14) dans les modules de batterie associés à l'unité de mesure min-max (33) respective et rejeter les valeurs de tension intermédiaires,
**caractérisé en ce que** le premier microcontrôleur (23),
côté basse tension, est relié à un premier capteur de courant, notamment un capteur à effet Hall (27), et le deuxième microcontrôleur (25), côté haute tension, est relié à un deuxième capteur de courant différent du premier capteur de courant, notamment un capteur de courant pourvu d'une résistance shunt (26).

2. Système de gestion de batterie (31, 41, 51) selon la revendication 1, avec lequel les premières unités de mesure de tension (42) sont reliées au moyen de la première liaison de communication (36) conformément à une première topologie de communication et les deuxièmes unités de mesure de tension (32) sont reliées au moyen de la deuxième liaison de communication (34) conformément à une deuxième topologie de communication, différente de la première topologie de communication.

3. Système de gestion de batterie (31, 41, 51) selon la revendication 1 ou 2, avec lequel la première topologie de communication présente un arrangement en guirlande (20) et la deuxième topologie de communication présente une liaison à bus CAN, ou inversement.

4. Système de gestion de batterie (31, 41, 51) selon l'une des revendications précédentes, lequel est configuré de telle sorte que les premier et deuxième microcontrôleurs (23, 25) fonctionnent indépendamment l'un de l'autre.

5. Système de gestion de batterie (31, 41, 51) selon l'une des revendications précédentes, avec lequel le premier microcontrôleur (23), côté basse tension, est conçu pour interpréter des tensions électriques et possède en outre une fonction de sécurité, et le deuxième microcontrôleur (25), côté haute tension, est conçu pour déterminer un état de charge (SOC).

6. Système de gestion de batterie (31, 41, 51) selon l'une des revendications précédentes, avec lequel le premier ainsi que le deuxième microcontrôleur (32, 42) sont configurés sous la forme d'unités de mesure min-max (33).

7. Système de gestion de batterie (31, 41, 51) selon l'une des revendications précédentes, comprenant plusieurs unités de surveillance de cellule (35, 45, 55) respectivement équipées de l'une des premières unités de mesure de tension et de l'une des deuxièmes unités de mesure de tension et comprenant un microcontrôleur (38), les unités de mesure de tension d'une unité de surveillance de cellule (35, 45, 55) étant connectées à des entrées communes de l'unité de surveillance de cellule (35, 45, 55) et le microcontrôleur (38) dans l'unité de surveillance de cellule (35, 45, 55) étant conçu pour interpréter les données de l'une des unités de mesure de tension (32, 42) de l'unité de surveillance de cellule (35, 45, 55) respective.

8. Procédé de surveillance d'une batterie, selon lequel un état de charge (SOC) est déterminé et la présence de tensions minimale et maximale est surveillée, **caractérisé par** l'utilisation de topologies de communication différentes fonctionnant indépendamment les unes des autres, d'une part pour la détection des valeurs de tension servant à la détermination de l'état de charge, et d'autre part pour la détection des valeurs de tension servant à la surveillance des tensions minimale et maximale, des unités de mesure min-max (33) selon la revendication 1 étant utilisées au moins pour la détection des valeurs de tension servant à la surveillance des tensions minimale et maximale.

9. Batterie dotée d'un système de gestion de batterie (31, 41, 51) selon l'une des revendications 1 à 7.

10. Véhicule automobile équipé d'un système de gestion de batterie (31, 41, 51) selon l'une des revendications 1 à 7, la batterie à surveiller étant reliée à un système d'entraînement du véhicule automobile.
